# EUROPÄISCHE PATENTSCHRIFT

(11) **EP 0 761 038 B1**
(45) Veröffentlichungstag und Bekanntmachung des Hinweises auf die Patenterteilung: **20.01.1999**
(21) Anmeldenummer: 95917906.0
(22) Anmeldetag: 12.05.1995
(51) Int. Cl.: H03J 5/24, H03B 5/12

(54) **FREQUENZVERÄNDERBARE OSZILLATORANORDNUNG**
VARIABLE-FREQUENCY OSCILLATOR CIRCUIT
DISPOSITIF A OSCILLATEUR A FREQUENCE VARIABLE

(30) Priorität: 26.05.1994 DE 4418432
(43) Veröffentlichungstag der Anmeldung: 12.03.1997
(73) Patentinhaber: SIEMENS AKTIENGESELLSCHAFT, 80333 München (DE)
(72) Erfinder: HOHMANN, Henning, D-81243 München (DE)
(86) Internationale Anmeldenummer: DE9500636
(87) Internationale Veröffentlichungsnummer: WO9533307

(56) Entgegenhaltungen:
- DE-A- 2 249 086
- US-A- 3 813 615
- US-A- 4 160 213

## Beschreibung

Die Erfindung betrifft eine frequenzveränderbare Oszillatoranordnung, die ein Verstärkernetzwerk und ein Rückkopplungsnetzwerk enthält.

Frequenzveränderbare Oszillatoren werden beispielsweise als Überlagerungsoszillatoren (Lokaloszillatoren) in Tunern verwendet, um aus dem hochfrequenten Antennensignal ein Signal bei einer fest vorgegebenen Zwischenfrequenz zu erzeugen. Eine solche Oszillatoranordnung ist beispielsweise in dem Lehrbuch Limann/Pelka, "Fernsehtechnik ohne Ballast", 14. Auflage, 1993, Seiten 91 bis 93, gezeigt. Dabei ist das Verstärkernetzwerk innerhalb einer integrierten Schaltung realisiert. Das Rückkopplungsnetzwerk ist als äußere Beschaltung der integrierten Schaltung aus diskreten Bauelementen aufgebaut. Das Verstärkernetzwerk ist symmetrisch realisiert, so daß Störeinflüsse von und nach außen nicht wirksam werden. Das Rückkopplungsnetzwerk ist umschaltbar, so daß es für beide VHF-Frequenzbänder verwendet werden kann. Das Rückkopplungsnetzwerk weist allerdings den Nachteil einer unsymmetrischen Realisierung auf. Dies bedeutet, daß die Schaltung hochfrequenzmäßig auf Bezugspotential einwirkt. Dies hat zur Folge, daß erhöhter Aufwand zur Abschirmung und Stabilisierung der Schaltung notwendig ist.

Darüber hinaus sind weitere Lösungen bekannt, bei denen zwar Oszillatoren mit symmetrischen Rückkopplungsnetzwerken verwendet werden, die allerdings nicht umschaltbar sind. Für jeden der VHF-Frequenzbänder ist dann ein eigener Oszillator notwendig.

In der US-Patentschrift US 3 813 615 ist ein lokaler Oszillator für einen Fernsehtuner gezeigt, der zwischen verschiedenen Frequenzbändern umschaltbar ist. Das frequenzbestimmende Netzwerk weist eine zwischen einen Eingang eines Oszillatortransistors und Masse geschaltete Reihenschaltung aus zwei Schwingkreisinduktivitäten und einer Schwingkreiskapazität auf. Parallel dazu liegt die Reihenschaltung einer weiteren Schwingkreiskapazität und einer veränderbaren Kapazität. Am Kopplungsknoten zwischen den Induktivitäten ist eine Diode angeschlossen, mittels der gesteuert durch ein Schaltsignal die bezugspotentialseitige Induktivität überbrückbar ist. Zur Rückkopplung des Verstärkers ist zwischen Basis und Emitter des Verstärkertransistors ein Kondensator angeschlossen, der über einen weiteren Kondensator mit Masse verbunden ist. Das frequenzbestimmende Netzwerk sowie der Verstärkertransisotor sind in bezug auf Masse unsymmetrisch ausgeführt und weisen eine hochfrequenzmäßig wirksame Verbindung mit Masse auf.

In der US-Patentschrift 4 160 213 ist eine Tuneranordnung mit umschaltbarem Frequenzbereich für ein Fernsehgerät beschrieben. Diese enthält einen lokalen Oszillatortransistor sowie ein mit diesem verbundenes frequenzbestimmendes Element, das die Reihenschaltung aus zwei Schwingkreisinduktivitäten und einer Kapazität enthält und nach Masse geschaltet ist. Über eine an den Kopplungsknoten der Induktivitäten geschaltete Diode ist die masseseitige Induktivität überbrückbar. Sowohl Oszillatortransistor als auch frequenzbestimmendes Element wirken in bezug auf Masse unsymmetrisch.

Der Erfindung liegt die Aufgabe zugrunde, eine frequenzveränderbare Oszillatoranordnung anzugeben, die in bezug auf die Hochfrequenzwirkung symmetrisch arbeitet und eine Umschaltung zwischen verschiedenen Frequenzbereichen ermöglicht.

Diese Aufgabe wird durch eine frequenzveränderbare Oszillatoranordnung gelöst, enthaltend ein Verstärkernetzwerk und ein Rückkopplungsnetzwerk, das einen ersten und einen zweiten Anschluß aufweist, die an Signalanschlüsse des Verstärkernetzwerks angeschlossen sind, wobei das Rückkopplungsnetzwerk die folgenden Merkmale aufweist: Die Reihenschaltung einer ersten und einer zweiten Schwingkreisinduktivität und einer ersten Schwingkreiskapazität ist zwischen die Anschlüsse geschaltet, die erste Schwingkreiskapazität ist mit dem zweiten Anschluß verbunden, die Reihenschaltung einer veränderbaren Schwingkreiskapazität und einer zweiten Schwingkreiskapazität ist zwischen die Anschlüsse geschaltet, an den Kopplungsknoten von erster und zweiter Schwingkreisinduktivität sind Schaltmittel angeschlossen, durch die in Abhängigkeit von einem Schaltsignal der Kopplungsknoten in bezug auf Hochfrequenzsignale mit dem zweiten Anschluß verbindbar ist.

Durch die symmetrisch wirkende Schaltung ergibt sich der Vorteil, daß versorgungsspannungsseitig keine Störeinflüsse auf die Schaltung einwirken. Darüber hinaus bewirkt die symmetrische Ausführung, daß kaum Hochfrequenzabstrahlung auftritt. Aufwendige Vorkehrungen zur Abschirmung sind deshalb nicht notwendig. Durch die Möglichkeit der Umschaltung zwischen verschiedenen Frequenzbereichen kann dasselbe Rückkopplungsnetzwerk für beide VHF-Frequenzbänder benutzt werden. Insgesamt ergibt sich also eine symmetrisch wirkende Schaltung mit geringem Bauelementeaufwand.

Nachfolgend wird die Erfindung anhand der in der Zeichnung dargestellten Figuren näher erläutert. Es zeigen
- Figur 1: eine erfindungsgemäße Oszillatoranordnung,
- Figur 2: ein Ersatzschaltbild des Rückkopplungsnetzwerks für einen ersten Frequenzbereich und
- Figur 3: ein Ersatzschaltbild des Rückkopplungsnetzwerks für einen zweiten Frequenzbereich.

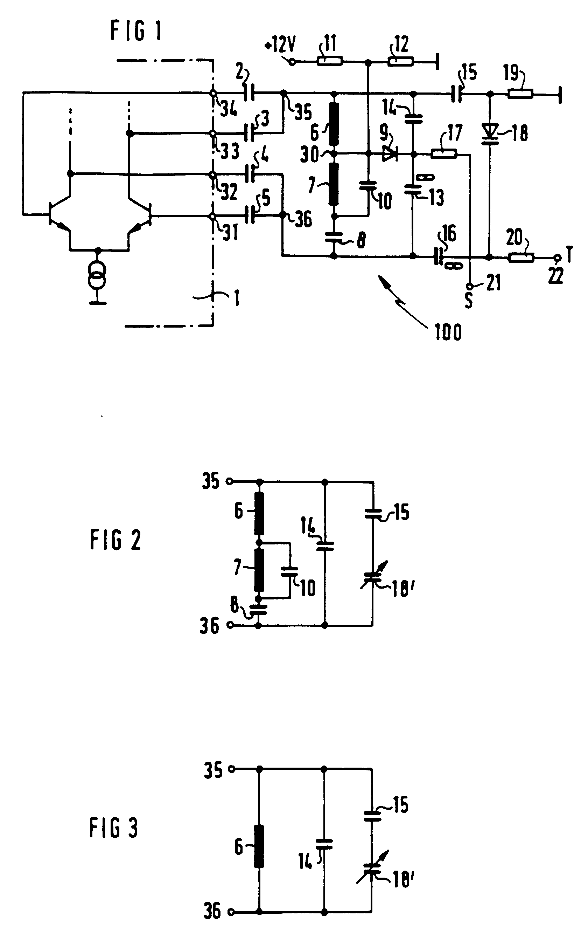

Die Oszillatoranordnung gemäß Figur 1 enthält einen Differenzverstärker 1 in Bipolarausführung, der üblicherweise als integrierte Schaltung realisiert wird. Eingänge 31, 34 und Ausgänge 32, 33 des Verstärkers werden nach außen geführt, um mit einem Rückkopplungsnetzwerk 100 verbunden zu werden. Das Rückkopplungsnetzwerk 100 weist einen ersten Anschluß 35 und einen zweiten Anschluß 36 auf, die jeweils über Koppelkondensatoren 2...5 mit den Ein- bzw. Ausgängen des Verstärkers 1 verbunden sind.

Das Rückkopplungsnetzwerk enthält zwischen den Anschlüssen 35, 36 die Reihenschaltung aus einer ersten und einer zweiten Induktivität 6, 7 und eines Kondensators 8. Die Induktivitäten 6, 7 bilden hochfrequent wirksame Schwingkreisinduktivitäten, der Kondensator 8 eine hochfrequent wirksame Schwingkreiskapazität. Die Spule 6 ist dabei an den Anschluß 35 angeschlossen, der Kondensator 8 an den Anschluß 36. Der Kopplungsknoten zwischen den Spulen 6, 7 ist mit dem Bezugszeichen 30 bezeichnet.

Parallel zur genannten Reihenschaltung liegt eine Reihenschaltung aus einem weiteren als Schwingkreiskondensator wirkenden Kondensator 15 und einer veränderbaren Kapazität 18. Die veränderbare Kapazität 18 ist als Kapazitätsdiode ausgeführt, deren Anodenanschluß an den Kondensator 15 und deren Katodenanschluß an den Anschluß 36 gekoppelt ist. Zur Gleichstromversorgung ist der Kopplungsknoten zwischen Diode 18 und Kondensator 15 über einen Widerstand 19 mit Bezugspotential (Masse) verbunden. Der wirksame Kapazitätswert der Diode 18 wird über einen Anschluß 22, der über einen Widerstand 20 mit der Katode der Diode 18 verbunden ist, eingestellt. Am Anschluß 22 liegt üblicherweise eine Abstimmspannung T an. Zur Entkopplung der übrigen Schaltung von Gleichsignalanteilen wird der Knoten zwischen Widerstand 20 und Diode 18 über einen Kondensator 16 an den Anschluß 36 angekoppelt. Das Symbol ∞ am Kondensator 16 soll andeuten, daß dieser Kondensator für niedrigfrequente Signale und Gleichstrom-/Gleichspannungssignale als Leerlauf, für Hochfrequenzsignale jedoch als Kurzschluß wirkt.

Der Verbindungsknoten 30 zwischen den Spulen 6, 7 ist mit einem Schaltmittel 9, 17, 21 verbunden. Durch einen entsprechenden Signalpegel eines Signals S am Anschluß 21 kann der Knoten 30 hochfrequenzmäßig mit dem Anschluß 36 des Rückkopplungsnetzwerks verbunden werden. Dies bewirkt, daß die Spule 7 und der Kondensator 8 unwirksam sind. Die Schaltmittel enthalten im einzelnen eine Diode 9, deren Anode mit dem Knoten 30 und deren Katode über einen Widerstand 7 mit dem Anschluß 21 verbunden ist. Die Katode der Diode 9 ist über einen Kondensator 13 mit dem zweiten Anschluß 36 des Rückkopplungsnetzwerks verbunden. Anodenseitig wird eine konstante Spannung eingespeist, vorzugsweise in der Mitte der Versorgungsspannung. Dies erfolgt zweckmäßigerweise mittels eines zwischen die Versorgungsspannungsanschlüsse geschalteten ohmschen Spannungsteilers 11, 12. Der Kondensator 13 ist wiederum derart dimensioniert, daß er für Hochfrequenzsignale als Kurzschluß wirkt. Es sind zwei weitere Kondensatoren 10, 14 vorgesehen, die parallel zur Induktivitat 7 bzw. zwischen die Katode der Diode 9 und den ersten Anschluß 35 des Rückkopplungsnetzwerks geschaltet sind. Diese Kondensatoren 10, 14 dienen zur Gleichlaufeinstellung und zur Verbesserung des Temperaturgangs.

Die Schaltung arbeitet wie nachfolgend beschrieben: Als erster Fall wird betrachtet, daß das Signal S am Anschluß 21 einen H-Pegel aufweist. Die Diode 9 ist dann in Sperrichtung vorgespannt. Zwischen den Anschlüssen 35, 36 ist dann der in Figur 2 gezeigte Schwingkreis wirksam. Dieser besteht im wesentlichen aus den Induktivitäten 6, 7, zu denen der Kondensator 8 in Reihe liegt. Parallel dazu liegt der Kondensator 15 sowie die einstellbare Kapazität 18'. Der Kondensator 14 wirkt zwischen den Anschlüssen 35, 36, der Kondensator 10 parallel zur Induktivität 7. Die einstellbare Kapazität 18' dient zur Feinabstimmung auf den eingestellten Sender im Frequenzband.

Als zweiter Fall wird betrachtet, daß das Signal S am Anschluß 21 einen L-Pegel aufweist. Dann ist die Diode 9 in Flußrichtung vorgespannt, so daß deren Katode über den hochfrequenzmäßig als Kurzschluß wirkenden Kondensator 13 mit dem Anschluß 36 verbunden wird. Dadurch werden die Kondensatoren 8, 10 und die Induktivität 7 kurzgeschlossen. Der zwischen den Anschlüssen 35, 36 wirksame Schwingkreis besteht dann im wesentlichen aus der Induktivität 6, zu der jeweils der Kondensator 14 und die Reihenschaltung aus dem Kondensator 15 und der einstellbaren Kapazität 18' parallel liegen. Durch das Fehlen der frequenzbestimmenden Elemente 7, 8 wird der Oszillator in einem anderen Frequenzband betrieben. Mittels der einstellbaren Kapazität 18' kann wiederum innerhalb dieses Frequenzbands auf einen speziellen Sender abgestimmt werden.

## Patentansprüche

1. Frequenzveränderbare Oszillatoranordnung enthaltend ein Verstärkernetzwerk (1) und ein Rückkopplungsnetzwerk (100), das einen ersten und einen zweiten Anschluß (35, 36) aufweist, die an Signalanschlüsse des Verstärkernetzwerks (1) angeschlossen sind,
**dadurch gekennzeichnet,** daß
das Rückkoppelungsnetzwerk die folgenden Merkmale aufweist:
- die Reihenschaltung einer ersten und einer zweiten Schwingkreisinduktivität (6, 7) und einer ersten Schwingkreiskapazität (8) ist zwischen die Anschlüsse (35, 36) geschaltet,
- die erste Schwingkreiskapazität (8) ist mit dem zweiten Anschluß (36) verbunden,
- die Reihenschaltung einer veränderbaren Schwingkreiskapazität (18, 20, 22) und einer zweiten Schwingkreiskapazität (15) ist zwischen die Anschlüsse (35, 36) geschaltet,
- an den Kopplungsknoten (30) von erster und zweiter Schwingkreisinduktivität sind Schaltmittel (9, 17, 13, 21) angeschlossen, durch die in Abhängigkeit von einem Schaltsignal (S) der Kopplungsknoten (30) in bezug auf Hochfrequenzsignale mit dem zweiten Anschluß (36) verbindbar ist.

2. Oszillatoranordnung nach Anspruch 1,
**dadurch gekennzeichnet,** daß
die Schaltmittel umfassen:
- eine Diode (9), deren Anode mit dem Kopplungsknoten (30) verbunden ist und deren Katode mit einem Eingang (21) für das Schaltsignal verbunden ist,
- eine Spannungsquelle (11, 12), die mit der Anode der Diode (9) verbunden ist,
- eine erste Entkopplungskapazität (13) zur Entkopplung von Gleichsignalanteilen, durch die die Katode der Diode (9) mit dem zweiten Anschluß (36) verbunden ist.

3. Oszillatoranordnung nach Anspruch 2,
**dadurch gekennzeichnet,** daß
die Spannungsquelle ein zwischen Versorgungsspannungsanschlüsse geschalteter ohmscher Spannungsteiler (11, 12) ist.

4. Oszillatoranordnung nach Anspruch 2 oder 3,
**dadurch gekennzeichnet,** daß
ein Widerstand (17) zwischen die Katode der Diode (9) und den Eingang (21) für das Schaltsignal (S) geschaltet ist.

5. Oszillatoranordnung nach einem der Ansprüche 2 bis 4,
**dadurch gekennzeichnet,** daß
zwischen die Anode der Diode (9) und dem mit den Schwingkreisinduktivitäten (6, 7) verbunden Anschluß der Schwingkreiskapazität (8) ein Kondensator (10) geschaltet ist und daß zwischen die Katode der Diode (9) und den ersten Anschluß (35) ein weiterer Kondensator (14) geschaltet ist.

6. Oszillatoranordnung nach einem der Ansprüche 1 bis 5,
**dadurch gekennzeichnet,** daß
die veränderbare Schwingkreiskapazität enthält:
- eine Kapazitätsdiode (18), deren Anode über die zweite Schwingkreiskapazität (15) mit dem ersten Anschluß (35) verbunden ist und deren Katode über eine zweite Entkopplungskapazität (16) zur Entkopplung von Gleichsignalanteilen mit dem zweiten Anschluß (36) verbunden ist,
- einen Widerstand (20), der zwischen die Katode der Kapazitätsdiode (18) und einen Anschluß (22) für ein Abstimmsignal (T) geschaltet ist.

7. Oszillatoranordnung nach Anspruch 6,
**dadurch gekennzeichnet,** daß
die Anode der Kapazitätsdiode (18) über einen Widerstand (19) mit Bezugspotential (Masse) verbunden ist.

## Claims

1. Variable-frequency oscillator arrangement containing an amplifier network (1) and a feedback network (100), which is connected to the amplifier network (1) via a first and a second terminal (35, 36) and has the following features:
- the series circuit formed by a first and second resonant circuit inductor (6, 7) and a first resonant circuit capacitor (8) is connected between the terminals (35, 36),
- the resonant circuit capacitor (8) is connected to the second terminal (36),
- the series circuit formed by a variable resonant circuit capacitor (18, 20, 22) and a second resonant circuit capacitor (15) is connected between the terminals (35, 36),
- switching means (9, 17, 13, 21) are connected to the coupling node (30) between the first and second resonant circuit inductors, by virtue of which switching means the coupling node (30) can be connected, as a function of a switching signal (S), to the second terminal (36) with regard to highfrequency signals.

2. Oscillator arrangement according to Claim 1, characterized in that the switching means comprise:
- a diode (9), the anode of which is connected to the coupling node (30) and the cathode of which is connected to an input (21) for the switching signal,
- a voltage source (11, 12), which is connected to the anode of the diode (9),
- a first decoupling capacitor (13) for decoupling DC signal components, via which capacitor the cathode of the diode (9) is connected to the second terminal (36).

3. Oscillator arrangement according to Claim 2, characterized in that
the voltage source is a resistive voltage divider (11, 12).

4. Oscillator arrangement according to Claim 2 or 3, characterized in that a resistor (17) is connected between the cathode of the diode (9) and the input (21) for the switching signal (S).

5. Oscillator arrangement according to one of Claims 2 to 4, characterized in that a capacitor (10) is connected between the anode of the diode (9) and that terminal of the resonant circuit capacitor (8) which is connected to the resonant circuit inductors (6, 7), and in that a further capacitor (14) is connected between the cathode of the diode (9) and the first terminal (35).

6. Oscillator arrangement according to one of Claims 1 to 5, characterized in that the variable resonant-circuit capacitor contains:
- a variable capacitance diode (18), the anode of which is connected to the first terminal (35) via the second resonant circuit capacitor (15) and the cathode of which is connected to the second terminal (36) via a second decoupling capacitor (16) for decoupling DC signal components,
- a resistor (20), which is connected between the cathode of the variable capacitance diode (18) and a terminal (22) for a tuning signal (T).

7. Oscillator arrangement according to Claim 6, characterized in that the anode of the variable capacitance diode (18) is connected to reference potential (earth) via a resistor (19).

## Revendications

1. Montage oscillateur à fréquence variable, comprenant un réseau (1) amplificateur et un réseau (100) de rétrocouplage qui comporte une première borne (35) et une deuxième borne (36) qui sont raccordées à des bornes de signaux du réseau (1) amplificateur,
caractérisé en ce que le réseau de rétrocouplage comporte les caractéristiques suivantes :
- le circuit série d'une première inductance (6) de circuit oscillant et d'une deuxième inductance (7) de circuit oscillant et d'une première capacité (8) de circuit oscillant est branché entre les bornes (35, 36),
- la première capacité (8) de circuit oscillant est reliée à la deuxième borne (36),
- le circuit série d'une capacité (18, 20, 22) variable de circuit oscillant et d'une deuxième capacité (15) de circuit oscillant est branché entre les bornes (35, 36),
- il est raccordé au point (30) nodal de couplage de la première et de la deuxième inductances de circuit oscillant des moyens (9, 17, 13, 21) de commande par lesquels le point (30) nodal de couplage peut, en fonction d'un signal (S) de commande, être relié à la deuxième borne (36) pour ce qui concerne des signaux haute fréquence.

2. Montage oscillateur suivant la revendication 1, caractérisé en ce que les moyens de commande comprennent :
- une diode (9) dont l'anode est reliée au point (30) nodal de couplage et dont la cathode est reliée à une entrée (21) pour le signal de commande,
- une source (11, 12) de tension qui est reliée à l'anode de la diode (9),
- une première capacité (13) de découplage pour le découplage de composantes de signaux continus, par laquelle la cathode de la diode (9) est reliée à la deuxième borne (36).

3. Montage oscillateur suivant la revendication 2, caractérisé en ce que la source de tension est un diviseur (11, 12) de tension ohmique branché entre des bornes de tension d'alimentation.

4. Montage oscillateur suivant la revendication 2 ou 3, caractérisé en ce qu'une résistance (17) est montée entre la cathode de la diode (9) et l'entrée (21) pour le signal (S) de commande.

5. Montage oscillateur suivant l'une des revendications 2 à 4, caractérisé en ce qu'un condensateur (10) est monté entre l'anode de la diode (9) et la borne de la capacité (8) de circuit oscillant reliée aux inductances (6, 7) de circuit oscillant et en ce qu'un condensateur (14) supplémentaire est monté entre la cathode de la diode (9) et la première borne (35).

6. Montage oscillateur suivant l'une des revendications 1 à 5, caractérisé en ce que la capacité variable de circuit oscillant comprend :
- une diode (18) capacitive, dont l'anode est reliée à la première borne (35) par l'intermédiaire de la deuxième capacité (15) de circuit oscillant et dont la cathode est reliée à la deuxième borne (36) par l'intermédiaire d'une deuxième capacité (16) de découplage servant à découpler des composantes de signaux continus,
- une résistance (20), qui est montée entre la cathode de la diode (18) capacitive et une borne (22) pour un signal (T) de syntonisation.

7. Montage oscillateur suivant la revendication 6, caractérisé en ce que l'anode de la diode (18) capacitive est reliée au potentiel de référence (masse) par l'intermédiaire d'une résistance (19).
